# EUROPÄISCHE PATENTSCHRIFT

(11) **EP 2 734 852 B1**
(45) Veröffentlichungstag und Bekanntmachung des Hinweises auf die Patenterteilung: **17.10.2018**
(21) Anmeldenummer: 12738067.3
(22) Anmeldetag: 09.07.2012
(51) Int. Cl.: G01R 31/36

(54) **BATTERIEMANAGEMENTSYSTEM UND VERFAHREN ZUR BESTIMMUNG DER LADEZUSTÄNDE VON BATTERIEZELLEN, BATTERIE UND KRAFTFAHRZEUG MIT BATTERIEMANAGEMENTSYSTEM**
BATTERY MANAGEMENT SYSTEM AND METHOD FOR DETERMINING THE CHARGE STATE BATTERY CELLS, BATTERY AND MOTOR VEHICLE COMPRISING A BATTERY MANAGEMENT SYSTEM
SYSTÈME DE GESTION DE BATTERIE ET PROCÉDÉ DE DÉTERMINATION DES ÉTATS DE CHARGE D'ÉLÉMENTS DE BATTERIE, BATTERIE ET VÉHICULE À MOTEUR COMPORTANT UN SYSTÈME DE GESTION DE BATTERIE

(30) Priorität: 18.07.2011 DE 102011079291
(43) Veröffentlichungstag der Anmeldung: 28.05.2014
(73) Patentinhaber: Robert Bosch GmbH, 70442 Stuttgart (DE); Samsung SDI Co., Ltd., Yongin-si, Gyeonggi-do 446-577 (KR)
(72) Erfinder: BUTZMANN, Stefan, 71717 Beilstein (DE); FINK, Holger, 70567 Stuttgart (DE)
(74) Vertreter: Bee, Joachim
(86) Internationale Anmeldenummer: PCT/EP2012/063343
(87) Internationale Veröffentlichungsnummer: WO 2013/010831

(56) Entgegenhaltungen:
- US-B1- 6 781 343

## Beschreibung

Die vorliegende Erfindung betrifft ein Verfahren zur Bestimmung der Ladezustände von Batteriezellen oder Batteriemodulen einer Batterie unter Verwendung einer Mehrzahl von Zellüberwachungseinheiten, von denen jede mehrere von den Batteriezellen oder mindestens ein Batteriemodul überwacht. Die Erfindung betrifft außerdem ein dazugehöriges Batteriemanagementsystem zur Durchführung des Verfahrens sowie eine Batterie und ein Kraftfahrzeug.

### Stand der Technik

Es zeichnet sich ab, dass in Zukunft sowohl bei stationären Anwendungen, wie zum Beispiel Windkraftanlagen, in Fahrzeugen, wie zum Beispiel in Hybrid- und Elektrofahrzeugen, als auch im Consumer-Bereich, wie zum Beispiel bei Laptops und Mobiltelefonen, vermehrt neue Batteriesysteme zum Einsatz kommen werden, an die sehr hohe Anforderungen bezüglich deren Zuverlässigkeit, Sicherheit, Leistungsfähigkeit und Lebensdauer gestellt werden.

Für solche Aufgaben sind insbesondere Batterien mit Lithium-Ionen-Technologie geeignet. Sie zeichnen sich unter anderem durch hohe Energiedichte und eine geringe Selbstentladung aus. Definitionsgemäß bestehen Lithium-Ionen-Batterien aus zwei oder mehreren Lithium-Ionen-Zellen, die miteinander verschaltet sind. Lithium-Ionen-Zellen können durch parallele oder serielle Verschaltung zu Modulen, und dann zu Batterien verschaltet werden. Typischerweise besteht ein Modul aus sechs oder mehr Zellen.

Aus der DE 10 2009 046 567 A1 ist eine Batterie bekannt, die aus mehreren Batteriemodulen aufgebaut ist, wobei die Batteriemodule mittels eines zentralen Batteriemanagementsystems überwacht werden.

US 6,781,343 B1 beschreibt ebenfalls ein Batteriesystem, welches mittels eines zentralen Batteriemanagementsystems überwacht wird. In der vorliegenden Beschreibung kann je nach Zusammenhang die Gesamtheit der in Batteriemodulen angeordneten Batteriezellen mit oder ohne das dazugehörige Batteriemanagementsystem als Batterie bezeichnet werden. Ferner kann der Begriff Zellüberwachungseinheit mit CSC (Englisch: "Cell Supervision Circuit) abgekürzt werden, und Ladezustand mit SOC (Englisch: "State of Charge").

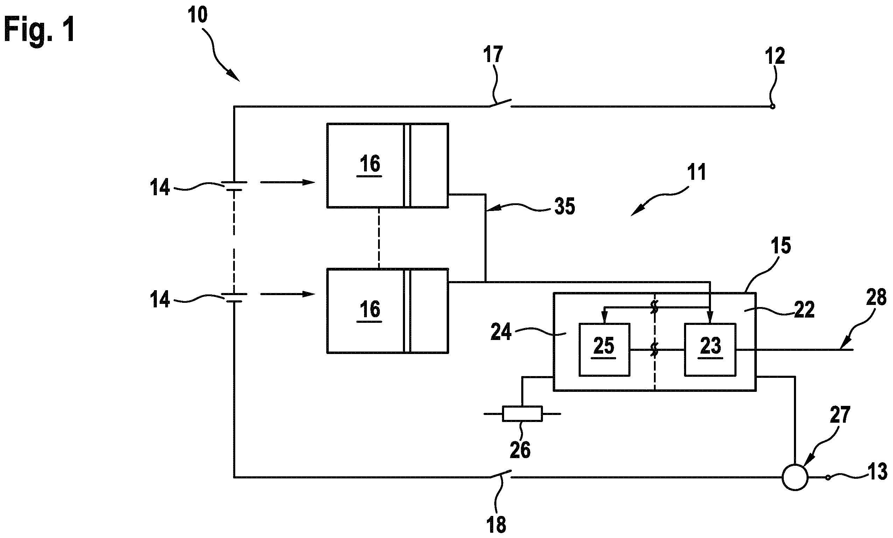

Im Folgenden wird anhand von Figur 1 ein beispielhaftes Batteriesystem 10 gemäß dem Stand der Technik beschrieben, das eine Batterie mit Batteriezellen 14 sowie ein Batteriemanagementsystem (BMS) 11 aufweist. Wie in Figur 1 jeweils durch eine unterbrochene Linie angedeutet, weist das Batteriesystem 10 eine Batterie mit vielen Batteriezellen 14, sowie viele Zellüberwachungseinheiten 16 auf. Die Batteriezellen 14 sind in Batteriemodule gruppiert, wobei die genaue Aufteilung der Batteriezellen in die Batteriemodule in Figur 1 nicht gezeigt ist. Das Batteriemanagementsystem 11 kann mit Batteriezellen 14 oder Batteriemodulen in einem gemeinsamen Gehäuse (nicht gezeigt) untergebracht sein. Die Batteriemodule können jeweils ein eigenes Gehäuse aufweisen. Mittels einer Anordnung der Batteriezellen 14 in Batteriemodule kann eine bessere Skalierbarkeit erreicht werden. Um die ordnungsgemäße Funktion der Batteriezellen 14 zu überwachen, werden die Batteriezellen durch mehrere CSC 16 überwacht. Eine CSC 16 beinhaltet eine Messelektronik, die die Spannung und weitere Parameter überwacht. Die mittels der CSC 16 gewonnenen Informationen werden über einen Kommunikationsbus 35, beispielsweise einen CAN-Bus, an ein zentrales Steuergerät 15 gesendet, das die Daten aller Batteriezellen 14 auswertet und bei Abweichungen von definierten Parametern korrigierend eingreift oder notfalls die Schütze 17, 18 öffnet und das Batteriesystem 10 abschaltet. Das Steuergerät 15 ist ferner über den Bus 28 mit einer Kraftfahrzeugelektronik (nicht gezeigt) verbunden.

Um die ordnungsgemäße Funktion der Batteriezellen 14 zu überwachen, werden bei dem Batteriemanagementsystem 11 typischerweise je zwei Module durch eine CSC 16 überwacht. Um eine ausreichende funktionale Sicherheit für das Batteriesystem 10 zu gewährleisten, werden die Daten der CSCs 16 sowohl auf der Hochvoltseite 24 als auch auf der Niedervoltseite 22 des Steuergerätes 15 in zwei redundanten Mikrocontrollern 23, 25 ausgewertet und miteinander verglichen. Der hochvoltseitige Mikrocontroller 25 verwendet dabei die Gesamtspannung des Packs, das heißt aller Batteriemodule sowie den Gesamtstrom, der beispielsweise mittels des Shunts 26 gemessen wird. Der niedervoltseitige Mikrocontroller 23 misst die Spannung der einzelnen Batteriezellen 14 sowie den Strom, der beispielsweise über den Hall-Sensor 27 ermittelt wird. Typischerweise wird auf der Niedervoltseite des Steuergeräts auch der Ladezustand des Batteriepacks berechnet. Dazu werden durch das Steuergerät zeitgleich Strom- und Spannungswerte der Batteriezellen abgefragt, die für die Berechnung des SOC relevant sind.

Nachteilig an einem solchen Batteriesystem ist, dass viele Daten über die Kommunikationsleitungen laufen müssen, an die das Steuergerät und die Zellüberwachungseinheiten angeschlossen sind, womit eine erhöhte Bandbreite beansprucht wird. Dies ist insbesondere nachteilig bei einem Kraftfahrzeug, in dem ein CAN-Bus oder ein anderes Bussystem verwendet wird.

### Offenbarung der Erfindung

Es wird ein Verfahren zur Bestimmung der Ladezustände (SOC) von Batteriezellen oder Batteriemodulen einer Batterie geschaffen, wie es in dem unabhängigen Anspruch 1 angegeben ist.

Ein entsprechendes Batteriemanagementsystem, eine Batterie und ein Kraftfahrzeug mit Batteriemanagementsystem werden in unabhängigen Vorrichtungsansprüchen 4, 5 und 6 beansprucht. Bei dem Verfahren wird eine Mehrzahl von Zellüberwachungseinheiten (CSC) verwendet, von denen jede mehrere von den Batteriezellen oder mindestens ein Batteriemodul überwacht. Das erfindungsgemäße Verfahren umfasst grundsätzlich die folgenden Schritte: Messen der jeweiligen elektrischen Spannung der Batteriezellen oder Batteriemodule durch die Zellüberwachungseinheiten, Messen eines Stromes der Batterie, Übermitteln des gemessenen Stromwertes an die Mehrzahl von Zellüberwachungseinheiten und Berechnen eines SOC in jeder von den Zellüberwachungseinheiten für die jeweiligen überwachten Batteriezellen beziehungsweise das jeweilige mindestens eine Batteriemodul.

Ein Vorteil des erfindungsgemäßen Verfahrens ist, dass die Datenrate, die über den Kommunikationsbus läuft, reduziert wird. So kann bei einer Batterie, die in eine Mehrzahl von Batteriemodulen aufgeteilt ist, denen viele Zellüberwachungseinheiten zugeordnet sind, die Übermittlung von Daten entfallen, die zur Berechnung der Ladezustände in einem zentralen Steuergerät benötigt werden. Stattdessen wird lediglich ein einzelner Wert für den gemessenen Batteriestrom übermittelt. Das erfindungsgemäße Verfahren macht sich vorteilhaft zunutze, dass es zur Bestimmung des Ladezustands von einzelnen Batteriemodulen beziehungsweise Batteriezellen ausreicht, wenn der global ermittelte Stromwert verwendet wird. Die Spannungswerte werden weiterhin lokal ermittelt.

Außerdem wird die Reduzierung der Datenrate erfindungsgemäß auf eine besonders einfache Weise ohne erhöhten Hardware-Aufwand erreicht. Im Vergleich zu einem Verfahren beispielsweise, bei dem auch der Strom lokal ermittelt wird, bietet das erfindungsgemäße Verfahren eine Reduzierung des erforderlichen Aufwands: So wird erfindungsgemäß ein herkömmlicher globaler Stromsensor verwendet und der Strom wird global gemessen, was auch eine erhöhte Sicherheit bedeutet. Daher kann erfindungsgemäß auf elegante Weise ein lokaler, Batteriemodul-bezogener SOC in den CSCs berechnet werden, ohne dass diese einen eigenen Stromsensor aufweisen müssen, was nämlich neben hohen Kosten auch einen vergleichsweise hohen Aufwand in der Steuerung und Plausibilisierung mit sich bringen würde.

Vorteilhafte Weiterbildungen der Erfindung sind in den Unteransprüchen angegeben und in der Beschreibung beschrieben.

So ist es in einer besonderen, nicht in der Erfindung umfassten Ausführungsform vorgesehen, dass ein Triggersignal an die Zellüberwachungseinheiten übermittelt wird. Die elektrischen Spannungen werden in den Zellüberwachungseinheiten auf das Triggersignal hin gemessen. Dadurch wird besonders vorteilhaft eine einfache Synchronisation der Spannungsmessungen erreicht.

Gemäß einer vorteilhaften Weiterbildung dieser besonderen, nicht in der Erfindung umfassten Ausführungsform wird das Triggersignal von einem Steuergerät des die Batterie überwachenden Batteriemanagementsystems über eine separate Triggerleitung an die Zellüberwachungseinheiten gesendet. Dabei verbindet die Triggerleitung das Steuergerät mit den Zellüberwachungseinheiten. Durch diese Vorgehensweise wird die Steuerung des Verfahrens vereinfacht.

Gemäß einer Ausführungsform der Erfindung wird auf die Triggerleitung verzichtet und die Spannungsmessungen werden stattdessen beispielsweise auf die Übermittlung des Stromwerts hin vorgenommen.

Gemäß der Erfindung werden die Ladezustände in Antwort auf den übermittelten Stromwert von den Zellüberwachungseinheiten ermittelt und zurück an das Steuergerät gesendet.

Das erfindungsgemäße Verfahren wird durch eine Niedervoltseite des Steuergeräts gesteuert. Dabei kann insbesondere ein auf der Niedervoltseite redundant vorhandener Mikrocontroller verwendet werden, wodurch eine effektive Arbeitsteilung im Steuergerät und ein hohes Sicherheitsniveau ASIL (Englisch: "automotive safety integrity level") erreicht werden kann.

Dabei ist es gemäß der Erfindung vorgesehen, dass die Niedervoltseite den Batteriestrom auf einer Hochvoltseite des Steuergeräts abfragt, oder eine Anfrage startet, was die Hochvoltseite veranlasst, den Wert des Batteriestroms auszugeben.

Gemäß einer Ausführungsform ist es vorgesehen, dass die verfahrensgemäße Ansteuerung der Zellüberwachungseinheiten über zwei separate Kommunikationsleitungen erfolgt. Dabei wird bevorzugt, dass die zwei Kommunikationsleitungen die Niedervoltseite und die Hochvoltseite des Steuergeräts separat mit jeweils einem anderen Mikrocontroller in einer Zellüberwachungseinheit koppeln.

Bei dieser Ausführungsform können vorteilhaft modifizierte Zellüberwachungseinheiten verwendet werden, die redundante Hardware aufweisen und eine redundante Topologie verwenden, um parallel mittels der zwei separaten Kommunikationsleitungen kommunizieren zu können.

Gemäß einer Weiterbildung dieser Ausführungsform wird der Batteriestrom von der Hochvoltseite über eine der zwei Kommunikationsleitungen an die Zellüberwachungseinheiten ausgegeben.

Alternativ teilt die Hochvoltseite der Niedervoltseite den Stromwert mit, woraufhin die Niedervoltseite den Stromwert übermittelt.

Gemäß der Erfindung wird der Batteriestrom mittels eines Shunts durch einen auf der Hochvoltseite des Steuergeräts angeordneten Mikrocontroller ermittelt.

Erfindungsgemäß wird ferner ein Batteriemanagementsystem bereitgestellt, das ein Steuergerät, mindestens einen Stromsensor und mehrere Zellüberwachungseinheiten aufweist, wobei das Batteriemanagementsystem eingerichtet ist, das Verfahren nach einem der vorhergehenden Ansprüche durchzuführen.

Außerdem wird eine Batterie mit dem erfindungsgemäßen Batteriemanagementsystem geschaffen, und ein Kraftfahrzeug mit dem erfindungsgemäßen Batteriemanagementsystem, wobei die zu überwachende Batterie mit einem Antriebsstrang des Kraftfahrzeugs verbunden ist.

### Zeichnungen

Ausführungsbeispiele der Erfindung werden anhand der Zeichnungen und der nachfolgenden Beschreibung näher erläutert. Es zeigen:
Figur 1 eine Batterie mit einem Batteriemanagementsystem gemäß dem Stand der Technik,
Figur 2 eine Batterie mit einem Batteriemanagementsystem gemäß einer Ausführungsform der Erfindung,
Figur 3 Komponenten einer Batterie und einer Zellüberwachungseinheit gemäß einer anderen Ausführungsform der Erfindung, wobei in der Zellüberwachungseinheit ein Ladezustand ermittelt wird, und
Figur 4 die Batterie mit Batteriemanagementsystem gemäß der in Figur 3 gezeigten Ausführungsform, wobei eine redundante Topologie mit zwei separaten Kommunikationsbussen dargestellt ist.

### Ausführungsformen der Erfindung

In der folgenden ausführlichen Beschreibung und in den beigefügten Zeichnungen weisen gleiche Bezugszeichen auf gleiche oder ähnliche Komponenten hin.

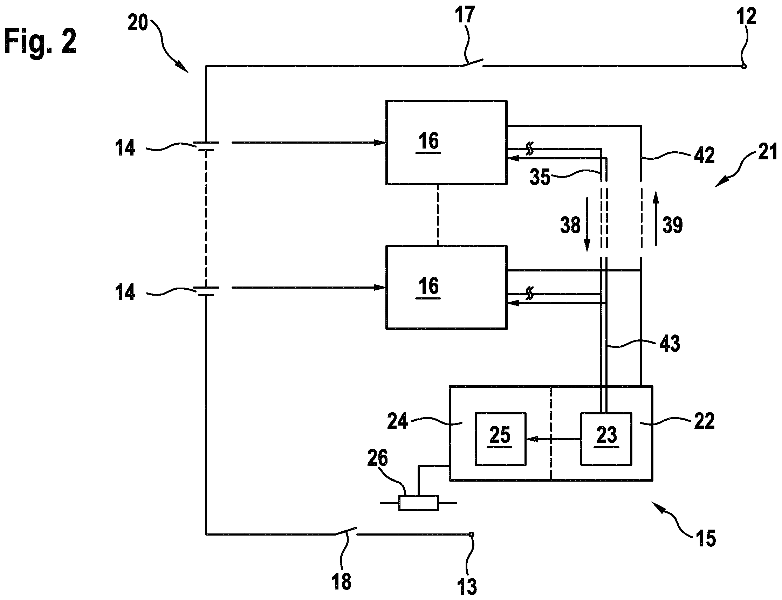

In Figur 2. ist ein Batteriesystem 20 aus einer Batterie mit einem Batteriemanagementsystem 21 gemäß einer Ausführungsform der Erfindung gezeigt.

Der Batteriestrom wird zentral durch die Hochvoltseite 24 des Steuergeräts 15 gemessen. Diese Informationen werden an die CSCs 16 übermittelt zum Zwecke der genauen Bestimmung der SOC 38 der einzelnen Module.

Das Batteriemanagementsystem 21 weist entsprechende Mittel in der Hardware, Software und/oder Firmware, den Elektronikbauteilen und/oder den Datenverbindungen auf, so dass es für das erfindungsgemäße Verfahren hinreichend angepasst ist. Das Verfahren soll durch die Niedervoltseite 22 des Steuergerätes 15 gesteuert werden. Die Niedervoltseite 22 sorgt dafür, dass die Spannung in allen CSCs 16 gleichzeitig gemessen wird, indem sie ein Triggersignal 39 über die Triggerleitung 43 an die CSCs 16 schickt. Alternativ wird gemäß einer Variante dieser Ausführungsform eine Anfrage über den Kommunikationsbus 35, hier: ein CAN-Bus, geschickt.

Parallel fragt die Niedervoltseite 22 den Strom auf der Hochvoltseite 24 ab. Der genaue Stromwert, der mittels eines Shunts 26 durch den hochvoltseitigen Mikrocontroller 25 ermittelt wird, wird dann durch den Kommunikationsbus 35 an die CSCs 16 übermittelt. Die CSCs 16 können nun den jeweiligen SOC 38 ausrechnen, und zurück an das Steuergerät 15 senden, wie in der Figur 2 auch angedeutet ist. Das Batteriemanagementsystem 31 weist ferner eine Alarmleitung 42 auf, die die CSCs 16 mit dem Steuergerät 15 verbindet und dazu dienen kann, bei einem kritischen Wert des SOC oder einer Spannung einen Alarm auszugeben. Auf diesen Alarm hin wird korrigierend eingegriffen oder ein Schütz 17, 18 geöffnet, um das Batteriesystem 20 abzuschalten.

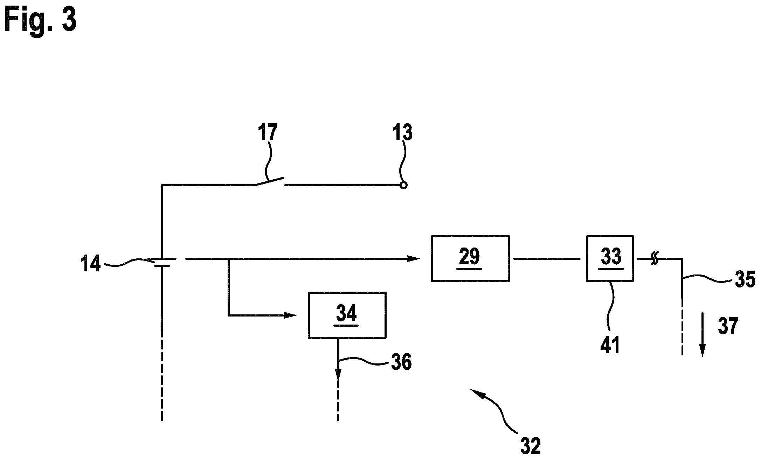

In Figur 3 werden Komponenten einer Batterie mit einer CSC 32 gemäß einer anderen Ausführungsform der Erfindung gezeigt. Die CSC 32 weist einen Mikrocontroller 33 auf, in dem der SOC 38 des Batteriemoduls ermittelt wird, wie in der Figur 3 durch das Bezugszeichen 41 angedeutet wird. Der SOC wird ermittelt in Antwort auf eine Übermittlung des Stromwertes an die CSC 31. Der Mikrocontroller 33 übermittelt diesen Wert dann an das Steuergerät. Die CSC 32 ist mit einer Zellspannungsmesseinheit 29 bestückt. Als Zellspannungsmesseinheit 29 kann eine CVM-Einheit (Englisch: "cell voltage monitor") verwendet werden. Die CSC 32 hat außerdem eine zweite Messeinheit 34, die als CVM oder als Min-Max-Messeinheit ausgebildet sein kann, wobei die Min-Max-Messeinheit lediglich die minimale und die maximale Spannung in dem Batteriemodul ausgibt. Die CSC 32 kann noch Werte für andere physikalische Größen, wie beispielsweise die Temperatur, ermitteln. Insgesamt werden über den Kommunikationsbus 35 weniger Daten 37 gesendet und der Aufwand im Steuergerät wird reduziert. So enthalten die Daten 37 gemäß dem Ausführungsbeispiel lediglich den Batteriemodul-SOC, die minimale Spannung, die maximale Spannung sowie eine Temperatur.

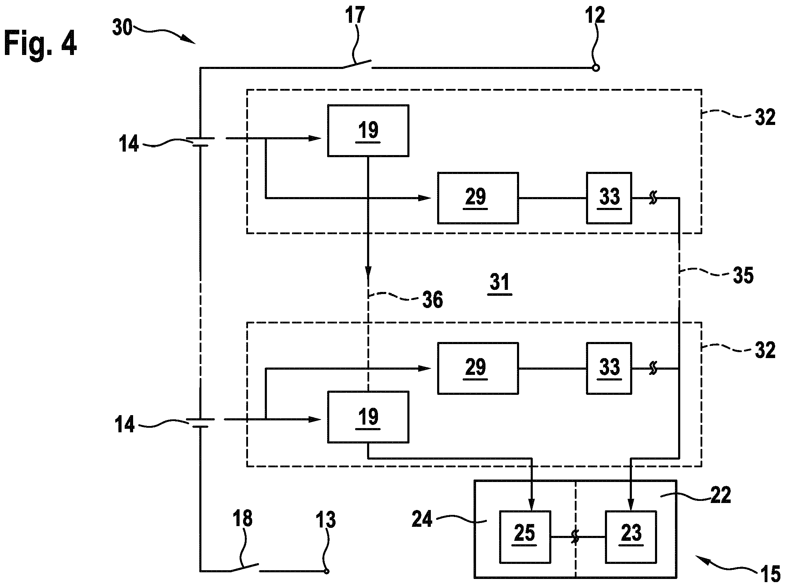

In Figur 4 ist die redundante Topologie mit zwei separaten Kommunikationsbussen der in Figur 3 gezeigten Ausführungsform dargestellt. Die Messelektronik des Batteriemanagementsystems 31 ist redundant ausgelegt, jede CSC 31 weist zwei CVMs 19, 29 auf. Die Mikrocontroller 23, 25 werden mit zwei separaten Kommunikationsleitungen 35, 36 angesteuert, jede der Kommunikationsleitungen ist mit einem CVM 19, 29 je CSC verbunden. Die beiden Arten von CVM 19, 29 können gleicher oder unterschiedlicher Bauart sein. Ferner können auch die Kommunikationsleitungen 35, 36 verschiedener Art sein. Beispielsweise kann die mit der Hochvoltseite gekoppelte Kommunikationsleitung auch eine Daisy-Chain-Architektur bereitstellen. Die in Figur 4 gezeigte Topologie ist bevorzugt dazu geeignet, das erfindungsgemäße Verfahren durchzuführen. Zunächst kann die Hardware-Redundanz zu einem verminderten Software-Aufwand in dem Steuergerät 15 führen. Ferner können die Kommunikationsleitungen 35, 36 dazu verwendet werden, die Komponenten in den CSCs 31 verfahrensgemäß anzusteuern.

## Patentansprüche

1. Verfahren zur Bestimmung der Ladezustände (SOC) von Batteriezellen (14) oder Batteriemodulen einer Batterie unter Verwendung einer Mehrzahl von Zellüberwachungseinheiten (16, 32) und eines Steuergerätes (15), welches eine Hochvoltseite und eine Niedervoltseite aufweist, wobei das Verfahren durch die Niedervoltseite des Steuergeräts gesteuert wird, wobei jede Zellüberwachungseinheit (16, 32) mehrere von den Batteriezellen (14) oder mindestens ein Batteriemodul überwacht, mit den Schritten:
Globales Ermitteln des Batteriestroms mittels eines Shunts (26) durch einen hochvoltseitigen Mikrocontroller (25),
Abfragen des Batteriestroms auf der Hochvoltseite des Steuergeräts durch die Niedervoltseite.
Übermitteln des global ermittelten Stromwerts an die Mehrzahl von Zellüberwachungseinheiten (16, 32) durch die Niedervoltseite,
Messen einer jeweiligen elektrischen Spannung der Batteriezellen (14) oder Batteriemodule durch die Zellüberwachungseinheiten (16, 32) auf den übermittelten, global ermittelten Stromwert hin,
Ermitteln eines Ladezustandes (SOC) durch jede der Zellüberwachungseinheiten (16, 32) für die jeweiligen überwachten Batteriezellen (14) beziehungsweise das jeweilige mindestens eine Batteriemodul in Antwort auf den übermittelten Stromwert,
Zurücksenden der ermittelten Ladezustände in Antwort auf den übermittelten Stromwert von den Zellüberwachungseinheiten (16, 32) an die Niedervoltseite des Steuergeräts (15).

2. Verfahren gemäß Anspruch 1, wobei das Messen der jeweiligen elektrischen Spannung der Batteriezellen (14) oder Batteriemodule durch die Zellüberwachungseinheiten (16, 32) synchron erfolgt.

3. Verfahren nach einem der vorhergehenden Ansprüche, wobei die Ansteuerung der Zellüberwachungseinheiten (16, 32) über zwei separate Kommunikationsleitungen (35, 36) erfolgt.

4. Batteriemanagementsystem (21, 31), aufweisend ein Steuergerät (15), mindestens einen Stromsensor (26), und mehrere Zellüberwachungseinheiten (16, 32), und ferner dazu eingerichtet, das Verfahren nach einem der vorhergehenden Ansprüche 1 bis 3 durchzuführen.

5. Batterie mit einem Batteriemanagementsystem (21, 31) nach Anspruch 4.

6. Kraftfahrzeug mit einem Batteriemanagementsystem (21, 31) nach Anspruch 4, wobei die zu überwachende Batterie mit einem Antriebsstrang des Kraftfahrzeugs verbunden ist.

## Claims

1. Method for determining the states of charge (SOC) of battery cells (14) or battery modules of a battery using a plurality of cell monitoring units (16, 32) and a controller (15) that has a high-voltage side and a low-voltage side, the method being controlled by the low-voltage side of the controller, each cell monitoring unit (16, 32) monitoring multiple instances of the battery cells (14) or at least one battery module, having the steps of:
the battery current being globally ascertained by means of a shunt (26) by a high-voltage-side microcontroller (25),
the battery current on the high-voltage side of the controller being sensed by the low-voltage side,
the globally ascertained current value being transmitted into the plurality of cell monitoring units (16, 32) by the low-voltage side,
a respective voltage of the battery cells (14) or battery modules being measured by the cell monitoring units (16, 32) in view of the transmitted, globally ascertained current value,
a state of charge (SOC) being ascertained by each of the cell monitoring units (16, 32) for the respective monitored battery cells (14) or the respective at least one battery module in response to the transmitted current value,
the ascertained states of charge being returned in response to the transmitted current value from the cell monitoring units (16, 32) to the low-voltage side of the controller (15).

2. Method according to Claim 1, wherein the respective voltage of the battery cells (14) or battery modules is measured by the cell monitoring units (16, 32) synchronously.

3. Method according to either of the preceding claims, wherein the cell monitoring units (16, 32) are actuated via two separate communication lines (35, 36) .

4. Battery management system (21, 31), having a controller (15), at least one current sensor (26) and multiple cell monitoring units (16, 32), and further being set up to perform the method according to one of the preceding Claims 1 to 3.

5. Battery having a battery management system (21, 31) according to Claim 4.

6. Motor vehicle having a battery management system (21, 31) according to Claim 4, wherein the battery to be monitored is connected to a drive train of the motor vehicle.

## Revendications

1. Procédé pour la détermination des états de charge (SOC) d'éléments de batterie (14) ou de modules de batterie d'une batterie en utilisant une pluralité d'unités de surveillance d'éléments (16, 32) et un appareil de commande (15), lequel présente un côté de haute tension et un côté de basse tension, dans lequel le procédé est commandé par le côté de basse tension de l'appareil de commande, dans lequel chaque unité de surveillance d'éléments (16, 32) surveille plusieurs des éléments de batterie (14) ou au moins un module de batterie, avec les étapes suivantes :
la détermination globale du courant de batterie au moyen d'un shunt (26) par un microcontrôleur (25) du côté de haute tension,
l'interrogation du courant de batterie sur le côté de haute tension de l'appareil de commande par le côté de basse tension,
la transmission de la valeur de courant déterminée globalement à la pluralité d'unités de surveillance d'éléments (16, 32) par le côté de basse tension,
la mesure d'une tension électrique respective des éléments de batterie (14) ou modules de batterie par les unités de surveillance d'éléments (16, 32) concernant la valeur de courant déterminée globalement transmise,
la détermination d'un état de charge (SOC) par chacune des unités de surveillance d'éléments (16, 32) pour les éléments de batterie (14) respectifs surveillés ou l'au moins un module de batterie respectif en réponse à la valeur de courant transmise,
le renvoi des états de charge transmis en réponse à la valeur de courant transmise par les unités de surveillance d'éléments (16, 32) au côté de basse tension de l'appareil de commande (15).

2. Procédé selon la revendication 1, dans lequel la mesure de la tension électrique respective des éléments de batterie (14) ou modules de batterie s'effectue de manière synchrone par les unités de surveillance d'éléments de batterie (16, 32).

3. Procédé selon l'une des revendications précédentes, dans lequel la commande des unités de surveillance d'éléments (16, 32) s'effectue via deux lignes de communication (35, 36) séparées.

4. Système de gestion de batterie (21, 31) présentant un appareil de commande (15), au moins un détecteur de courant (26) et plusieurs unités de surveillance d'éléments (16, 32), et en outre étudié pour mettre en oeuvre le procédé selon l'une des revendications 1 à 3 précédentes.

5. Batterie avec un système de gestion de batterie (21, 31) selon la revendication 4.

6. Véhicule à moteur avec un système de gestion de batterie (21, 31) selon la revendication 4, dans lequel la batterie à surveiller est reliée à un groupe motopropulseur du véhicule à moteur.
